# EUROPEAN PATENT APPLICATION

(11) **EP 4 160 660 A1**
(43) Date of publication of application: **05.04.2023**
(21) Application number: 20938747.1
(22) Date of filing: 01.06.2020
(51) Int. Cl.: H01L 21/66

(54) **METHOD FOR EVALUATING OUTER PERIPHERAL DISTORTION OF WAFER**

(71) Applicant: Shin-Etsu Handotai Co., Ltd., Tokyo 100-0004 (JP)
(72) Inventor: ANDO, Yushi, Nishishirakawa-gun, Fukushima 961-8061 (JP)
(74) Representative: Sonnenhauser, Thomas Martin
(86) International application number: PCT/JP2020/021592
(87) International publication number: WO 2021/245741

(57) **Abstract**

The present invention is a method for evaluating a peripheral strain of a wafer having a polycrystalline film formed on a surface, the method including: using, as the wafer having the polycrystalline film formed on the surface, a wafer of a silicon single crystal substrate having a polycrystalline film formed on a surface; performing a pre-treatment of removing a surface of the polycrystalline film; subsequently allowing an infrared laser to enter a periphery of the wafer from a back surface; and evaluating the peripheral strain of the wafer from a polarization degree of the infrared laser transmitted through the wafer. This provides a method for evaluating a peripheral strain of a wafer having a polycrystalline film formed on a surface with high precision.

## Description

### TECHNICAL FIELD

The present invention relates to a method for evaluating a peripheral strain of a wafer.

### BACKGROUND ART

When an epitaxial layer is grown on a polished wafer by using a single wafer processing apparatus for manufacturing an epitaxial wafer, a strain generally occurs in a wafer periphery due to thermal stress and so forth applied to a contact portion between the wafer and a susceptor. As a method for evaluating this strain, a technique is employed, where an infrared laser is allowed to enter the wafer from a back surface, and the strain is detected from a polarization degree of the infrared laser after transmission through the wafer (Patent Document 1). In the present evaluation, the polarization degree of the incident light is large when the wafer has a strain, so that the strain can be detected from the polarization degree. Until now, when the present measurement is performed on an epitaxial wafer, the wafer having the epitaxial layer grown thereon has been measured as it is.

### CITATION LIST

### PATENT LITERATURE

Patent Document 1: JP 2012-019216 A

### SUMMARY OF INVENTION

### TECHNICAL PROBLEM

Meanwhile, in the case of a wafer having a polycrystalline film (poly film) grown thereon, too, growth is performed using a single wafer processing apparatus for manufacturing an epitaxial wafer, so that a strain occurs in a periphery of the wafer in the growth process by the same principles as in the case of the epitaxial wafer. The same evaluation method as that of the epitaxial wafer has also been employed for evaluating a strain of the wafer on which a polycrystalline film has been grown. However, in a wafer having a polycrystalline film formed thereon, the polycrystalline film has an irregular crystal orientation, etc., so that the evaluation method is easily influenced by noise, especially in peripheral portions. Therefore, application of the conventional measurement method has been difficult. Accordingly, establishment of a technique for evaluating a strain of a wafer having a polycrystalline film formed has been required.

The present invention has been made to solve the problems, and an object thereof is to provide a high-precision method for evaluating a peripheral strain of a wafer having a polycrystalline film formed on a surface.

### SOLUTION TO PROBLEM

The present invention has been made to achieve the object, and provides a method for evaluating a peripheral strain of a wafer having a polycrystalline film formed on a surface, the method comprising:
using, as the wafer having the polycrystalline film formed on the surface, a wafer of a silicon single crystal substrate having a polycrystalline film formed on a surface;
performing a pre-treatment of removing a surface of the polycrystalline film;
subsequently allowing an infrared laser to enter a periphery of the wafer from a back surface; and
evaluating the peripheral strain of the wafer from a polarization degree of the infrared laser transmitted through the wafer.

According to such an evaluation method, the influence of noise in the periphery at the time of measurement can be reduced, and the peripheral strain of the wafer having the polycrystalline film formed thereon can be evaluated accurately.

In this event, the pre-treatment can be performed by polishing and/or etching.

In this manner, the surface of the polycrystalline film can be smoothed, and/or the surface film thickness of the polycrystalline film can be thinned. Thus, it is possible to reduce the influence of the noise in the periphery at the time of measurement, and the evaluation of the peripheral strain of the wafer having the polycrystalline film formed can be carried out effectively and with high precision.

In this event, the pre-treatment can be performed by polishing to remove the surface by a thickness of 0.2 µm or more by polishing.

When the polished amount is in the above range, the influence of the noise in the periphery at the time of measurement can be reduced more effectively, and the evaluation of the peripheral strain of the wafer on which a polycrystalline film has been formed can be performed with higher precision.

Furthermore, the pre-treatment can be performed by etching to remove the surface by a thickness of 0.5 µm or more by etching.

When the amount removed by etching is in the above range, the influence of the noise in the periphery at the time of measurement can be reduced more effectively, and the evaluation of the peripheral strain of the wafer on which a polycrystalline film has been formed can be performed with higher precision.

The pre-treatment can be performed by vapor phase etching and/or liquid phase etching.

In this manner, the influence of the noise in the periphery at the time of measurement can be reduced, and the evaluation of the peripheral strain of the wafer on which a polycrystalline film has been formed can be performed simply.

### ADVANTAGEOUS EFFECTS OF INVENTION

As described above, according to the inventive method for evaluating a peripheral strain of a wafer having a polycrystalline film formed on a surface, the influence of noise on the periphery at the time of measurement can be reduced by performing a pre-treatment, and evaluation of the peripheral strain of a wafer having a polycrystalline film formed can be performed with high precision.

### BRIEF DESCRIPTION OF DRAWINGS

FIG. 1 schematically shows a single wafer processing apparatus for manufacturing an epitaxial wafer.
FIG. 2 shows a configuration of strain measurement equipment.
FIG. 3 is a plan view of a wafer, and shows a measurement exemption region and a measurement region.

### DESCRIPTION OF EMBODIMENTS

Hereinafter, the present invention will be described in detail, but the present invention is not limited thereto.

As described above, regarding a method for evaluating a peripheral strain of a wafer having a polycrystalline film formed on a surface, there has been desired a method for reducing the influence of noise in the periphery at the time of measurement to evaluate accurately the peripheral strain of the wafer having the polycrystalline film formed.

The present inventor has earnestly studied the above problems, and found out that it is possible to reduce the influence of noise in a periphery to measure accurately a peripheral strain of a wafer having a formed polycrystalline film by a method for evaluating a peripheral strain of a wafer having a polycrystalline film formed on a surface, the method comprising:
using, as the wafer having the polycrystalline film formed on the surface, a wafer of a silicon single crystal substrate having a polycrystalline film formed on a surface;
performing a pre-treatment of removing a surface of the polycrystalline film;
subsequently allowing an infrared laser to enter a periphery of the wafer from a back surface; and
evaluating the peripheral strain of the wafer from a polarization degree of the infrared laser transmitted through the wafer. Thus, the present invention has been completed.

Hereinafter, a description will be given with reference to the drawings.

The wafer having a polycrystalline film formed to be the object of the inventive method for evaluating a peripheral strain of a wafer may be manufactured by any method. For example, the wafer can be manufactured by using the apparatus for manufacturing an epitaxial wafer described below.

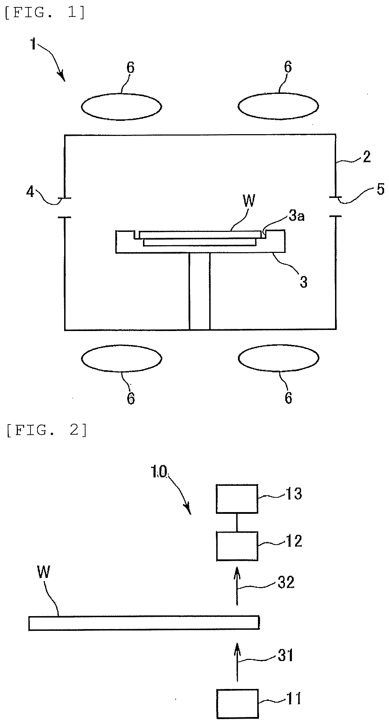

Firstly, a configuration of a single wafer processing apparatus for manufacturing an epitaxial wafer will be described with reference to FIG. 1. The epitaxial wafer manufacturing apparatus 1 of FIG. 1 is an apparatus in which a wafer W such as a silicon single crystal substrate is loaded one at a time, and a film such as a silicon single crystal film or a polycrystalline silicon film is formed on a main surface of the loaded wafer W by vapor deposition. In detail, the epitaxial wafer manufacturing apparatus 1 is configured to include: a reactor 2, into which the wafer W to be treated is loaded; a susceptor 3 for horizontally supporting the loaded wafer W arranged inside the reactor 2; and a heating unit 6 arranged to surround the reactor 2 for heating the inside of the reactor 2.

The susceptor 3 is, for example, made of graphite coated with silicon carbide (SiC), and is disc-shaped. At the top of the susceptor 3, a pocket 3a is formed for placing the wafer W horizontally, the pocket having a concave shape (a circular shape in a plan view) larger than the diameter of the wafer W by a few millimeters. The depth of pocket 3a is approximately the same as the thickness of the wafer W. In the example of FIG. 1, the bottom of the pocket 3a is formed to have a step shape so that the periphery of the wafer W is in contact with the pocket but the rest is not in contact. However, the pocket 3a may be formed so that the entire back surface of the wafer W is in contact with the bottom of the pocket 3a. The susceptor 3 is provided rotatably around the central axis thereof.

At one end of the reactor 2, a gas inlet 4 is formed for supplying various gasses onto the main surface of the wafer W inside the reactor 2. In addition, on the side of the reactor 2 opposite the gas inlet 4, a gas outlet 5 is formed for discharging the gas that has passed over the main surface of the wafer W. The heating unit 6 can be, for example, a halogen lamp provided respectively above and below the reactor 2.

Next, a configuration of an apparatus for measuring a peripheral strain of a wafer will be described with reference to FIG. 2. The measurement equipment 10 of FIG. 2 is configured as equipment employing the principles of SIRD (Scanning Infrared Depolarization). In detail, the measurement equipment 10 includes: a laser generator 11 for allowing an infrared laser 31 to enter the strain-measurement region of the wafer W to be measured; a detector unit 12 for detecting polarized components (P-polarized component and S-polarized component) of light 32 transmitted through the wafer W, which the infrared laser 31 entered; and a processing unit 13 for calculating the change in the polarization degree (amount of polarization change) on the basis of the polarized components detected in the detector unit 12 and performing a process such as the calculation of the position of a strain and the strained amount on the basis of the change in the polarization degree.

Next, procedures of the evaluation of a strain according to the present embodiment will be described. Firstly, a wafer whose strain is to be evaluated is prepared. As the wafer to be prepared, a wafer having a polycrystalline silicon film formed on a surface is prepared. The polycrystalline silicon film can be formed, for example, by using the single wafer processing apparatus 1 for manufacturing an epitaxial wafer shown as an example in FIG. 1. In this case, for example, the wafer W configured as a silicon single crystal substrate is placed in the pocket 3a of the susceptor 3, and in this state, a gas (e.g. trichlorosilane) to be a raw material for the polycrystalline silicon film and a carrier gas (e.g. hydrogen gas) are supplied from the gas inlet 4 to the inside of the reactor 2 while heating the wafer W to a predetermined temperature by using the heating unit 6, and thus, a polycrystalline silicon film having a predetermined film thickness is grown on the surface of the wafer W. In this manner, a wafer W having a polycrystalline silicon film on a surface can be obtained.

Next, a pre-treatment of removing a surface of the polycrystalline silicon film of the wafer W is performed. The method for the removal is not limited. By removing the surface of the polycrystalline silicon film of the wafer W, the influence of noise in the periphery during measurement can be reduced, so that the evaluation of a peripheral strain of the wafer can be carried out accurately.

For example, the surface of the polycrystalline silicon film of the wafer W is removed by polishing and/or etching, and then a strain measurement is performed. By performing the polishing before the strain measurement, the surface of the polycrystalline silicon film can be made smoother, so that the influence of noise in the periphery during measurement can be reduced, and the peripheral strain of the wafer can be evaluated accurately. Meanwhile, by performing the etching before the strain measurement, the surface film thickness of the polycrystalline silicon film can be thinned, so that the influence of noise in the periphery during measurement can be reduced, and the peripheral strain of the wafer can be evaluated accurately.

When the removal of the surface of the polycrystalline film is performed by polishing, the thickness to be removed by polishing can be 0.2 µm or more, and when performed by etching, the thickness to be removed by etching can be 0.5 µm or more. In this manner, the influence of the noise can be reduced more effectively, and the evaluation can be performed more accurately. Meanwhile, the upper limit of the amount of the polycrystalline film surface to be removed is not particularly limited, but from the viewpoint of throughput (productivity), the upper limit is preferably about 10 µm.

Here, as a method for polishing, a known substrate-polishing method can be adopted. Meanwhile, as the etching, vapor phase etching and/or liquid phase etching can be adopted, but the etching may be performed by any method as long as the surface can be removed. For example, in the case of vapor phase etching, hydrogen chloride can be used as an etching gas, and in the case of liquid phase etching, hydrofluoric acid or nitric acid can be used as an etching solution.

In the measurement of a strain, the infrared laser 31 is allowed to enter a back surface periphery of the wafer W since a strain often occurs in the back surface periphery, which is in contact with the susceptor 3.

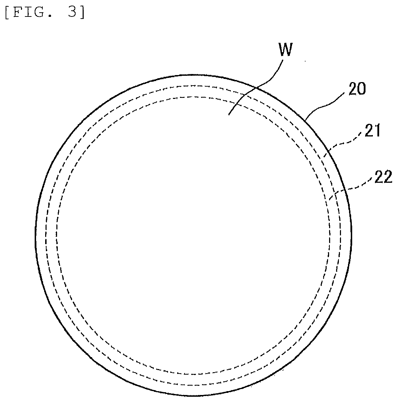

In addition, the strain measurement region 22 (see FIG. 3) in the wafer W is a region that includes the peripheral portion of the wafer W, and specifically, is a region of a predetermined width (e.g. a width of 4 mm) in the radial direction from the borderline of a measurement exemption region 21 on the side of the internal periphery. The strain measurement region 22 may be a region that covers the entire circumference of the inside of the outermost periphery 20 of the wafer W in the circumferential direction (i.e. a ring-shaped region), or a partial region in the circumferential direction. Next, by scanning (traversing) the position of incidence of the infrared laser 31 within the strain measurement region 22, the position of a strain and the strained amount in the strain measurement region 22 are evaluated.

### EXAMPLE

Hereinafter, the present invention will be described in detail with reference to Examples, but the present invention is not limited thereto.

### (Example 1)

Firstly, in a technique of measuring a strain of a wafer periphery including polishing a surface, the amount of peripheral strain was measured regarding each of an epitaxial wafer, conventionally an object to be measured, and a wafer having a polycrystalline film formed with the polycrystalline film removed by polishing, and the match rate of the strained amount was investigated.

The diameter of the wafers was 300 mm, and the epitaxial wafers were subjected to a reaction by using a single wafer processing apparatus for manufacturing an epitaxial wafer and thus fabricated. The wafers were loaded onto a susceptor inside a reactor of the epitaxial wafer manufacturing apparatus one by one, and while heating the wafer to a predetermined temperature (1100°C) with a heating unit, a gas (trichlorosilane) to be a raw material and a carrier gas (hydrogen) were supplied from a gas inlet to form, by vapor deposition, a silicon single crystal film having a film thickness of 5 µm on a surface of the wafer that had been loaded. Meanwhile, the wafers having a polycrystalline film formed were also subjected to a reaction by using the same apparatus as epitaxial wafers, but there is a characteristic that the heating temperature was in two stages. The reaction for the first layer was performed at a low temperature (900°C), and for the second layer, a high temperature (1100°C) to grow a polycrystalline film having a film thickness of 5 um. After that, a pre-treatment of removing a surface of the polycrystalline film by polishing was carried out at the removal amount shown in Table 1 below.

In the present Example, the match rate of the strain of the epitaxial wafers and the wafers each having a polycrystalline film formed was compared. It is known that since the places in the wafer periphery where a strain occurs are attributable to components such as the susceptor, the places of occurrence are not altered by a slight difference in reaction conditions. Therefore, regarding the places where a strain occurs in the epitaxial wafers, how much the places of occurrence in the wafers having a polycrystalline film formed matched was evaluated. Table 1 shows the relationship between the amount of polycrystalline film surface removed by polishing and the match rate of the strained amount.

Regarding the measurement region in the measurement of the peripheral strain, 0.5 mm of the outermost periphery was set as the measurement exemption region, and the strain measurement width was set to 4 mm. The measurement intervals were 2 mm in the circumferential direction and 1 mm in the radial direction.

### (Comparative Example 1)

Evaluation was carried out under the same conditions as in Example 1 except that the surface of the polycrystalline film was not removed by polishing (removed amount: 0 µm). As a result, the match rate was 42%, and the match rate was not sufficient.

As in Table 1, wafers were fabricated with the amount of polycrystalline film removed by polishing set to 0.1 um, 0.2 um, 0.4 um, 0.8 um, 1.6 um, and 4.0 um, and the match rates of the amount of strain that occurred were compared. As a result, when the amount of polycrystalline film surface removed by polishing was set to 0.1 µm, the match rate was 78%, and when set to 0.2 µm or more, the match rate was further improved, and was 90% or more. Since the match rate was 90% or more when the amount of polycrystalline film surface removed by polishing was 0.2 µm or more, the noise in the peripheral portion was successfully eliminated, and it was possible to evaluate the strained amount with high precision.

As demonstrated above, the peripheral strain evaluation of the wafers having a polycrystalline film formed was successfully carried out with high precision according to the Example of the present invention.

**[Table 1]**

| | Comparative Example 1 | Example 1 | | | | | |
|---|---|---|---|---|---|---|---|
| Amount of polycrystalline film removed (µm) | 0 | 0.1 | 0.2 | 0.4 | 0.8 | 1.6 | 4 |
| Match rate | 42% | 78% | 91% | 93% | 95% | 95% | 94% |

### (Example 2)

The removal of the polycrystalline film surface was performed by vapor phase etching, and the evaluation of the strain of the wafer periphery was performed. The amount of peripheral strain was measured regarding respectively the wafers of Example 1 having a polycrystalline film formed, the surface of the polycrystalline film being polished by 0.8 um, and wafers having a polycrystalline film formed, the polycrystalline film being removed by etching, and the match rate of the strained amount was investigated.

The method for fabricating the wafers having a polycrystalline film formed is the same as in Example 1, and the vapor phase etching was performed by supplying etching gas (hydrogen chloride) to the reactor after the growth of the polycrystalline film in the reactor of the epitaxial wafer manufacturing apparatus. Table 2 shows the relationship between the amount of polycrystalline film surface removed by vapor phase etching and the match rate of the strained amount.

The measurement region in the measurement of the peripheral strain was the same as in Example 1.

### (Example 3)

The removal of the polycrystalline film surface was performed by liquid phase etching, and the evaluation of the strain of the wafer periphery was performed. The amount of peripheral strain was measured regarding respectively the wafers of Example 1 having a polycrystalline film formed, the surface of the polycrystalline film being polished by 0.8 um, and wafers having a polycrystalline film formed, the polycrystalline film being removed by etching, and the match rate of the strained amount was investigated.

The method for fabricating the wafers having a polycrystalline film formed is the same as in Example 1, and the liquid phase etching was performed by using an etching solution (hydrofluoric acid) after taking the wafer out of the reactor. Table 3 shows the relationship between the amount of polycrystalline film surface removed by liquid phase etching and the match rate of the strained amount.

The measurement region in the measurement of the peripheral strain was the same as in Example 1.

### (Comparative Example 2)

When the conditions were set to the same conditions as in Example 1 except that the polycrystalline film surface was not removed (removed amount: 0 µm), the match rate was 45%, and the match rate was not sufficient.

As in Table 2, wafers were fabricated with the amount of polycrystalline film removed by vapor phase etching set to 0.2 µm, 0.4 um, 0.5 um, 1.0 um, 1.5 µm, and 3.0 um, and the match rates of the amount of strain that occurred were compared. As a result, when the amount of polycrystalline film surface removed by etching was set to 0.2 µm or more, the match rate was 60% or more, and when set to 0.5 µm or more, the match rate was further improved, and was 90% or more. Since the match rate was 90% or more when the amount of polycrystalline film surface removed by etching was 0.5 µm or more, the noise in the peripheral portion was successfully eliminated, and it was possible to evaluate the strained amount with high precision.

**[Table 2]**

| | Comparative Example 2 | Example 2 | | | | | |
|---|---|---|---|---|---|---|---|
| Amount of polycrystalline film removed (µm) | 0 | 0.2 | 0.4 | 0.5 | 1.0 | 1.5 | 3 |
| Match rate | 45% | 68% | 82% | 91% | 91% | 96% | 96% |

As in Table 3, wafers were fabricated with the amount of polycrystalline film removed by liquid phase etching set to 0.2 um, 0.4 µm, 0.5 µm, 1.0 um, 1.5 µm, 3.0 µm, and the match rates of the amount of strain that occurred were compared. As a result, when the amount of polycrystalline film surface removed by etching was set to 0.2 µm or more, the match rate was 60% or more, and when set to 0.5 um or more, the match rate was further improved, and was 90% or more. Since the match rate was 90% or more when the amount of polycrystalline film surface removed by etching was 0.5 um or more, the noise in the peripheral portion was successfully eliminated, and it was possible to evaluate the strained amount with high precision.

**[Table 3]**

| | Comparative Example 2 | Example 3 | | | | | |
|---|---|---|---|---|---|---|---|
| Amount of polycrystalline film removed (µm) | 0 | 0.2 | 0.4 | 0.5 | 1.0 | 1.5 | 3 |
| Match rate | 45% | 62% | 76% | 91% | 91% | 91% | 96% |

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for evaluating a peripheral strain of a wafer having a polycrystalline film formed on a surface, the method comprising:
using, as the wafer having the polycrystalline film formed on the surface, a wafer of a silicon single crystal substrate having a polycrystalline film formed on a surface;
performing a pre-treatment of removing a surface of the polycrystalline film;
subsequently allowing an infrared laser to enter a periphery of the wafer from a back surface; and
evaluating the peripheral strain of the wafer from a polarization degree of the infrared laser transmitted through the wafer.

2. The method for evaluating a peripheral strain of a wafer according to claim 1, wherein the pre-treatment is performed by polishing and/or etching.

3. The method for evaluating a peripheral strain of a wafer according to claim 2, wherein the pre-treatment is performed by polishing to remove the surface by a thickness of 0.2 µm or more by polishing.

4. The method for evaluating a peripheral strain of a wafer according to claim 2, wherein the pre-treatment is performed by etching to remove the surface by a thickness of 0.5 µm or more by etching.

5. The method for evaluating a peripheral strain of a wafer according to claim 2 or 4, wherein the pre-treatment is performed by vapor phase etching and/or liquid phase etching.
